# EUROPEAN PATENT APPLICATION

(11) **EP 1 172 864 A1**
(43) Date of publication of application: **16.01.2002**
(21) Application number: 01116568.5
(22) Date of filing: 09.07.2001
(51) Int. Cl.: H01L 31/048

(54) **Solar cell module**

(30) Priority: 11.07.2000 JP 2000209957; 05.09.2000 JP 2000269123
(71) Applicant: Sanyo Electric Co., Ltd., Moriguchi-shi, Osaka (JP)
(72) Inventor: Yoshimine, Yukihiro, Hiratakata-shi, Osaka-fu 573-0048 (JP); Nakashima, Saburo, Yawata-shi, Kyoto-fu 614-8334 (JP)
(74) Representative: Glawe, Delfs, Moll & Partner

(57) **Abstract**

This invention provides a solar cell module which can prevent degradation of reliability and insulation performance caused by film peeling in using a resin film to secure long-term reliability and insulation performance. The solar cell module is formed by sealing solar cells and a resin film by sealing resin between a front surface protecting layer of glass and a rear surface protecting layer of a transparent resin film. The resin film interposed between the front surface protecting layer and the rear surface protecting layer is formed inside from an edge of an overlaying area of both of the protecting layers.

## Description

### BACKGROUND OF THE INVENTION

### Field of the Invention

This invention relates to a solar cell module, particularly relates to a solar cell module with a resin film interposed in the module to insulate and avoid moisture.

### Description of Prior Art

Solar power generation which utilizes photovoltaic effect to convert photo energy into electrical energy has been used to obtain clean energy. As photovoltaic conversion efficiency of a solar cell has been improved, more ordinary households have been equipped with the solar power generation system. In using such the solar power generation system as a practical energy source, a plurality of solar cells are electrically connected in series to form a solar cell module.

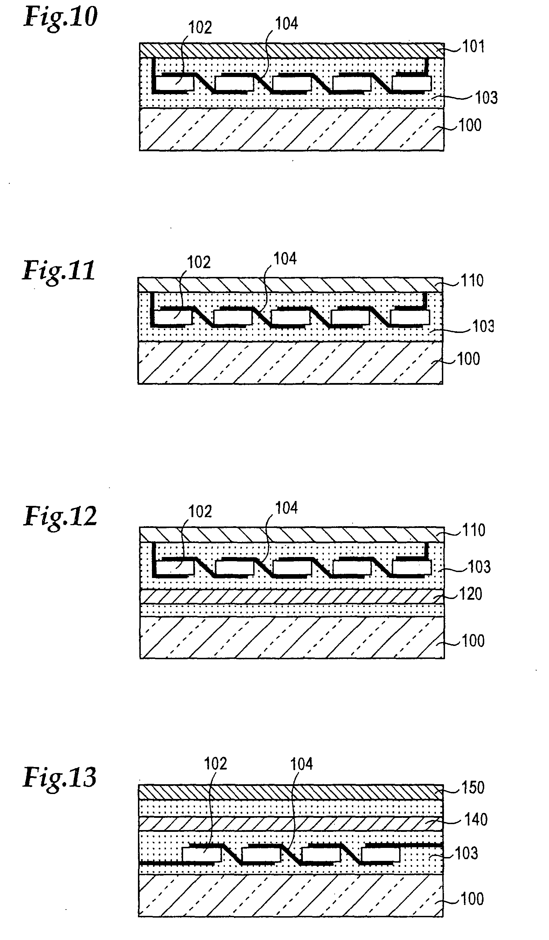

Fig. 10 illustrates one example of a structure of the solar cell module. As shown in Fig. 10, the solar cell module includes a front surface protecting layer 100 of such as a glass plate, a rear surface protecting layer 101 with an aluminum foil sandwiched between plastic films, a plurality of solar cells 102, and a sealing layer 103 of such as EVA (ethylene vinyl acetate). The sealing layer seals the plurality of solar cells between the front surface protecting layer 100 and the rear surface protecting layer 101. The solar cells 102 which are adjacent are electrically connected by a connecting member 104 of such as a copper foil.

A solar cell module which uses light incident not only from a front surface of the solar cell module but also from a rear surface of the solar cell module in order to efficiently use light has been known. Fig. 11 illustrates such the solar cell module. The same elements illustrated in Fig. 11 as in Fig. 10 have the same reference numbers as in Fig. 10 and explanation on them is omitted. The solar cell module shown in Fig. 11 includes a rear surface protecting layer 110 of a transparent plastic film which is formed by laminating a PET (polyethylene terephthalate) film and a fluoric film.

Another solar cell module improved to the solar cell module using the transparent plastic film as the rear surface protecting layer as shown in Fig. 11, which presents improved power generation performance, has been proposed (US patent application serial number 09/772,994). Fig. 12 illustrates the structure of such the solar cell module. The same elements illustrated in Fig. 12 as in Fig. 11 have the same reference numbers as in Fig. 11 and explanation on them is omitted. The solar cell module shown in Fig. 12 includes a transparent resin film 120 of such as a PET film formed in the sealing layer 103 between the front surface protecting layer 100 of a glass plate and the solar cells 102 in order to prevent elution and diffusion of alkaline component from the glass plate.

Another solar cell module which uses a metal plate as a rear surface film and is available as construction material has been known. Fig. 13 illustrates such the solar cell module. The elements illustrated in Fig. 13 as in Fig. 10 have the same reference numbers as in Fig. 10 and explanation on them is omitted. The solar cell module shown in Fig. 13 includes a rear surface protecting layer 150 of such as a steel plate, and a plastic film 140 of such as a PET film for insulation between the solar cells 102 and the rear surface protecting layer 150.

The resin film 120 between the front surface protecting layer 100 and the solar cells 102, and the insulating film 140 between the solar cells 102 and the rear surface protecting layer 150 are formed of a hard resin film (referred to a hard film herein after) of such as polyethylene terephthalate (PET). When the hard films are large enough to cover an entire surface of the solar cell module, end surfaces of the hard films are exposed outside. Therefore, water (vapor) intrudes from an interface between the hard films and the sealing resin 103 and adhesiveness of them may degrade.

It is difficult to maintain the front surface glass as the front surface protecting layer 100 and the hard film interposed therebetween flat when the module is a large one having one meter per side, and the front surface protecting layer 100 and the hard film are curved and are distorted differently. Thus, a degree of bend is different between the front surface glass and the hard film, and great force to peel the hard film is applied to the sealing resin 103 and the hard films 120, 140 on an end part of the module, leading to gradual degradation of adhesiveness between them.

Degradation of adhesiveness between the hard film and the sealing resin 103 causes easy intrusion of water (vapor) from the interface and the adhesiveness and the long-term reliability are further degraded. Such the problem also occurs when the hard film is formed either between the solar cells 102 and the front surface protecting layer 100 or between the solar cells 102 and the rear surface protecting layer 150.

### SUMMARY OF THE INVENTION

This invention was made to prevent degradation of output characteristics with time by preventing reliability degradation caused by film peeling, and securing long term reliability and insulating performance of a solar cell module by using a resin film (the above-mentioned hard film).

A solar cell module of this invention comprises a front surface protecting layer, a rear surface protecting layer, and solar cells and a resin film sealed by sealing resin between the front surface protecting layer and the rear surface protecting layer. The resin film is smaller in size than an overlaying area of both of the protecting layers.

When the solar cell module is a large one of one meter per side with the above structure, great peeling force is not applied to the resin film as the hard film at an end part of the module. As a result, reduction of adhesiveness of the sealing resin and the resin film is prevented and the resin film is prevented from being peeled. Thus, long-term reliability is maintained and degradation of the output characteristics with time can be prevented.

The resin film is preferably formed inside by at least 3 mm from the edge of the overlaying area of the front surface protecting layer and the rear surface protecting layer in terms of practical use.

When the resin film is formed between the front surface protecting layer and the solar cells, the resin film is preferably overlaid on an area including at least the solar cells within the overlaying area of the front surface protecting layer and the rear surface protecting layer.

When the resin film is formed between the solar cell and the rear surface protecting layer, the resin film is preferably overlaid on an area including at least the solar cells and wiring of the cells within the overlaying area of the front surface protecting layer and the rear surface protecting layer.

The wiring protruded from the resin film is preferably covered with an insulating tape to secure insulating performance.

The resin film is preferably a film which is previously heat-shrunk or a film of small heat shrinkage rate.

The rear surface protecting layer is preferably a film which is previously heat-shrunk or a film of small heat shrinkage rate.

By the above structure, deformation of a connecting member (a copper foil), changes in an interval between the solar cells caused by deformation of the resin film by heat do not have effects in manufacturing the solar cell module.

### BRIEF DESCRIPTION OF THE DRAWINGS

Fig. 1 is a schematic cross sectional view illustrating a first embodiment of this invention.

Fig. 2 is a schematic plan view illustrating the first embodiment of this invention.

Fig. 3 is a schematic cross sectional view illustrating a solar cell used in this invention.

Fig. 4 illustrates a manufacturing method of the solar cell module of this invention, using a heat-shrinkable resin film. Fig. 4A is a schematic cross sectional view of one example of manufacture of a rear surface protecting layer, and Fig. 4B is a schematic cross sectional view of one example of manufacture of a resin film.

Figs. 5A-5C are cross sectional view illustrating steps in manufacturing the solar cell module of the first embodiment.

Fig. 6 is a schematic cross sectional view illustrating a second embodiment of this invention.

Fig. 7 is a schematic plan view illustrating the second embodiment of this invention.

Fig. 8 is a schematic cross sectional view illustrating a manufacturing method of the solar cell module of this invention, using a heat-shrinkable resin film.

Figs. 9A-9C are cross sectional views illustrating steps in manufacturing the solar cell module of the second embodiment.

Fig. 10 is a schematic cross sectional view illustrating a conventional solar cell module.

Fig. 11 is a schematic cross sectional view illustrating a conventional solar cell module.

Fig. 12 is a schematic cross sectional view illustrating a conventional solar cell module.

Fig. 13 is a schematic cross sectional view illustrating a conventional solar cell module.

### DESCRIPTION OF PREFERRED EMBODIMENTS

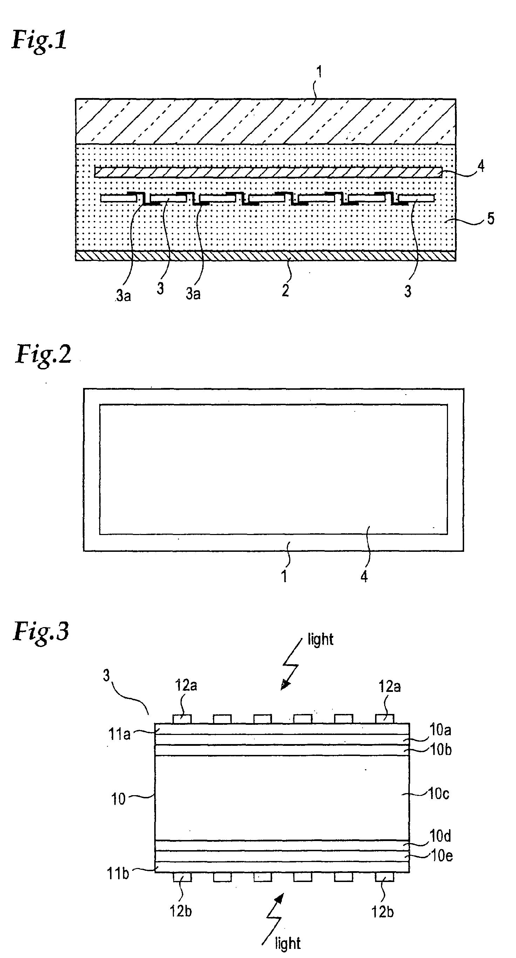

Explanation of the first embodiment of the invention is made by referring to Figs. 1-3.

A solar cell module of the first embodiment is a double side power generation type one capable of improving moisture proofness by forming a resin film between a front surface protecting layer of a glass plate and a solar cell.

Fig. 1 is the schematic cross sectional view of the solar cell module, and Fig. 2 is the schematic plane view. As shown in these figures, the solar cell module is formed by sealing a plurality of solar cells 3 and a resin film 4 equivalent to the above mentioned hard film by sealing resin 5 of such as EVA between a rear surface protecting layer 2 and a front surface protecting layer 1. The solar cells 3 which are adjacent are electrically connected by a connecting member 3a of such as a copper foil. The resin film 4 is a moisture proof resin layer having smaller vapor transmittivity than the sealing resin 5.

The rear surface protecting layer 2 is formed of two transparent films of PET and PVDF (polyvinylidene fluoride), and the front surface protecting layer 1 is formed of glass (the front surface glass). Both of the layers 1, 2 have a area of 1300 by 875 mm, as large as a module size, and an overlaying area of the protecting layers 1, 2 is equal to the module size.

The solar cell 3 has an HIT (Hetero-junction with Intrinsic Thin-layer) structure wherein a crystalline semiconductor and an amorphous semiconductor are joined. One example of the solar cell 3 is shown in Fig. 3.

A semiconductor layer 10 of the cell 3 includes a p-layer of a p-type a-Si (amorphous silicon) 10a, an i-layer of i-type a-Si 10b, an n-layer of n-type c-Si 10c, an i-layer of i-type a-Si 10d, and an n-type high doped layer of n-type a-Si 10e from a front side. Further transparent electrodes 11a, 11b of the transparent conductive films of such as an ITO film and comb-shaped collecting electrodes 12a, 12b of silver (Ag) are formed on the front and rear surfaces of the semiconductor layer 10. The p-layer 10a is 100-200Å in thickness. The i-layer 10b is 50-100Å in thickness. The i-layer 10d is 50-100Å in thickness. The n-type high doped layer 10e is 100-200Å in thickness. Each of the solar cells 3 is positioned inside the overlaying area of the protecting layers 1, 2.

The resin film 4 is formed of such as a PET hard film of 100 µm in thickness, and has a smaller area than the overlaying area of the protecting layers 1, 2. The resin film 4 is formed inside the edge of the overlaying area and is overlaid with an area including an array of the solar cells 3. A length from the edge of the resin film 4 to the edge of the overlaying area of the protecting layers 1, 2 is not less than 3 mm.

Thus, the resin film 4 has a smaller area than the overlaying area of the protecting layers 1, 2, and is formed so as to cover the area as large as or larger than the area of the array of the solar cells 3 inside the overlaying area.

To be concrete, the resin film 4 has an area of 1294 by 869 mm, and covers an area inside by 3 mm from the edge of the overlaying area of the protecting layers 1, 2.

In this case, the resin film 4 does not protrude from the overlaying area of the protecting layers 1, 2 and the edge part of the film 4 is covered with the sealing resin 5. Therefore, the adhesiveness of the resin film 4 and the sealing resin 5 is improved, and even when the solar cell module has a large area of one meter per side, the adhesiveness of the sealing resin 5 and the resin film 4 at an end edge part of the resin film 4 is not degraded, and the resin film 4 does not peel from the module. Therefore, moisture proofness of the solar cell module is improved and long-term reliability is securely obtained.

A module for comparison which includes a PET film (a film for comparison), instead of the resin film 4, of the size (1300 by 875 mm) same as the protecting layers 1, 2 is prepared. The module for comparison and the module of this embodiment including the resin film 4 are attached to an aluminum frame. And the modules are subject to a moisture proof test conducted with stress applied in conformance with the torsion test A-10 described in JIS C8917 Appendix No. 9 to apply great force to peel. The results are shown in Table 1.

The torsion test A-10 is conducted to examine mechanical durability of the solar cell module mounted to the supporting body. Four corners of a sample are removed from a rigid frame and are displaced to a certain amount, and the electrical conductivity and insulating resistance in the module are continuously measured. The moisture proof test is conducted at 85°C and RH 85%.

**[Table 1]**

| | Change rate of output characteristic | | | |
|---|---|---|---|---|
| | Pmax | Voc | Isc | F.F. |
| Module for comparison (after 1000 hours) | 99.5 | 99.9 | 99.9 | 99.7 |
| Module for comparison (after 2000 hours) | 96.5 | 99.0 | 99.5 | 98.0 |
| Module of the embodiment (after 1000 hours) | 99.5 | 99.9 | 99.9 | 99.7 |
| Module of the embodiment (after 2000 hours) | 98.0 | 99.5 | 99.7 | 98.8 |

This table shows change rates of characteristics, such as a maximum output (Pmax), an open-circuit voltage (Voc), an short-circuit current (Isc), and a fill factor (F. F.) of the module of the embodiment and the module for comparison after 1000 hours (1000 h) and after 2000 hours (2000 h).

As indicated by the change rates of the maximum output, there is little difference between the output characteristics of both of the modules before a lapse of 1000 hours and the modules present excellent reliability. However, the output characteristics of the module for comparison is greatly degraded after a lapse of 2000 hours while the module of the embodiment maintains high reliability without degrading the output characteristics.

After the test, the aluminum frames of both of the modules are removed, and adhesiveness of the resin film 4 and the film for comparison at the end of the modules are visually checked. Then, it is found that an interface between the film and the sealing resin 5 on the solar cell side of the comparison module only is peeled by approximately 1 mm.

Therefore, the adhesiveness of the film for comparison and the sealing resin 5 is degraded by great peeling force applied during the moisture proof test over 1000 hours, and the film for comparison is peeled at the end of the module. As a result, vapor intrudes between the film for comparison and the sealing resin 5 to degrade the output characteristics.

On the other hand, the resin film 4 of the module of the embodiment is formed inside by 3 mm from the edge of the overlaying area of the protecting layers 1, 2, and thus is not peeled even after the rigorous moisture proof test for 2000 hours conducted together with the torsion test. The output characteristics are degraded little and the long-term reliability is secured.

The above mentioned solar cell module is manufactured as follows. The front surface protecting layer 1 of the glass plate, a first resin layer as the sealing resin 5, the resin film 4, a second resin layer as the sealing resin 5, a plurality of the solar cells 3 electrically connected by a copper foil (a connecting member) 3a, a third resin layer as the sealing resin 5, and the rear surface protecting layer 2 of a plastic film are laminated in this order. Then, this lamination is held in a vacuum chamber of approximately 100 Pa, and is heated to approximately 90-130 °C, and is pressed from a rear surface protecting layer side with a silicone sheet using atmospheric pressure. In this process, the sealing layer of EVA resin is softened and tentatively adhered. These processes are referred to a vacuum lamination process herein after. Then, the lamination is held in a thermostatic chamber at approximately 150 °C for 30 minutes to thermally bridge the first, second, and third resin layers, and the resin film 4 and the solar cell 3 are sealed by the sealing resin 5 between the front surface protecting layer 1 and the rear surface protecting layer 2.

By the way, there is a problem that the PET films used as the rear surface protecting layer 2 and the resin film 4 heat-shrink in the heating process for thermal bridge, stress caused by the heat shrinkage is applied to the electrically connected solar cells to deform the copper foil (the connecting member) for connecting the solar cells and changes an interval between the adjacent solar cells. Such the problem occurs when more of the solar cells are electrically connected to form a large-sized solar cell module.

Because the resin film heat shrinks in the heat process, when a size of the resin film as the rear surface protecting layer before the vacuum lamination process is same as the size of the glass plate as the front surface protecting layer, the resin film serving as protection material is short at an edge, leading to degradation of weather proofness and water proofness. The resin film larger than the glass plate can solve this problem. However it is troublesome to cut off the redundant resin film.

Therefore, it is desired to manufacture a solar cell module which is little affected by heat shrinkage of the resin film in the heating process for thermally bridging the resin layer.

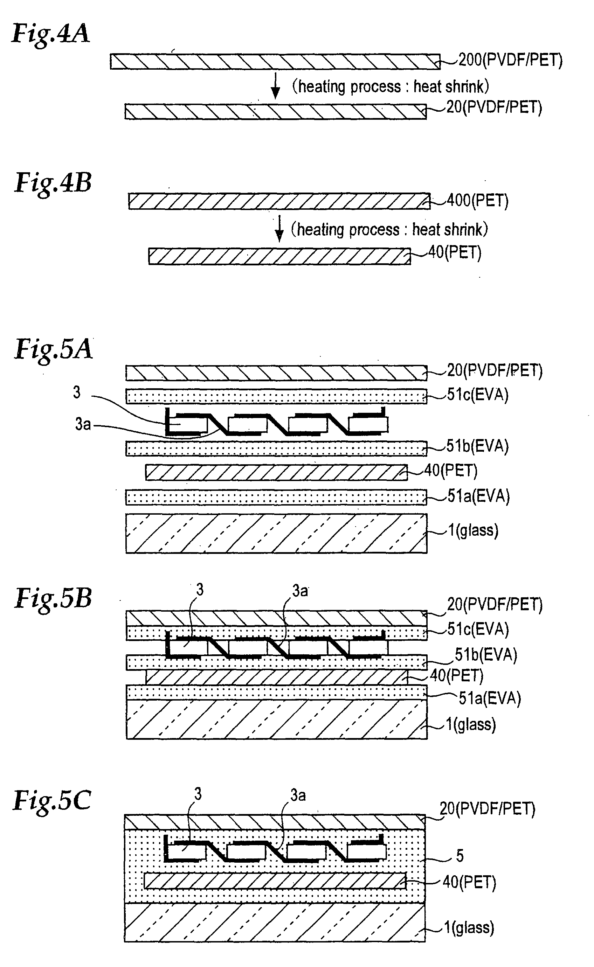

The manufacturing method of the solar cell module which uses a film little affected by the heat shrinkage of the resin film in the heating process is explained by referring to Figs. 4 and 5.

A resin film 200, as the rear surface protecting layer, formed of a lamination of a PVDF (polyvinylidene fluoride) film on an outer side (20 µm in thickness) and a PET film on an inner side (100 µm in thickness) is heat-shrunk by a heating process at 150°C for 30 minutes, same as a thermal bridge process described later, to obtain a rear surface protecting film 20 (see Fig. 4A). In this PVDF film, ultraviolet ray shielding material is coated or mixed to shield the ultraviolet rays. Therefore, the PET film and the EVA resin are prevented from yellowing by the ultraviolet rays.

A resin film 400 of a PET film (0.05-0.3 mm in thickness) is heat-shrunk by a heating process at 150°C for 30 minutes, same as a thermal bridge process described later, to obtain the resin film 40 for improving moisture proofness (see Fig. 4B). The heat-shrunk resin film 40 is formed so as to be smaller in size than the overlaying area of the rear surface protecting film 20 and the front surface protecting layer 1.

Then, the front surface protecting layer 1 of a glass plate (3-5 mm in thickness) with a reinforced front surface, a first resin layer 51a of EVA resin (0.4 mm in thickness), a resin film 40, a second resin layer 51b of EVA resin (0.4 mm in thickness), a solar cell array including a plurality of the solar cells 3 electrically connected by the copper foil 3a, a third resin layer 51c of EVA resin (0.6 mm in thickness), and the rear surface protecting film 20 are laminated in this order (see Fig. 5A).

As described above, the rear surface protecting film 20 is as large as the front surface protecting layer 1 of the glass plate. The resin film 4 is larger than the solar cell array, but is smaller than the first, second, and third resin layers 51a, 51b, 51c, the rear surface protecting film 20, and the front surface protecting layer 1.

This lamination is tentatively adhered by a vacuum lamination process (pressing for 2-10 minutes at 90-130°C) (see Fig. 5B). Then, the lamination is heated to thermally bridge the first, second, and third resin layers 51a, 51b, and 51c for example for 30 minutes at 150°C, and the lamination is integrated with the solar cell array and the resin film 4 sealed by the sealing layer 5 of EVA resin to form the solar cell module (see Fig. 5C).

It is desirable that a condition of the heating process satisfies that the heat shrinkage rate of the resin film after heating for 30 minutes at 150°C is 1.0 % or lower, more preferably 0.3% or lower. For example, in manufacturing a solar cell module of a rectangular shape of not longer than one meter per side, a resin film which is previously heat-shrunk so that the heat shrinkage rate by heating at 150°C for 30 minutes is 1.0 % or lower is used as the resin film and the rear surface protecting film in order to improve moisture proofness. Thus, the solar cell module can be manufactured with high yields. In manufacturing a large sized solar cell module of 1-2 meter per side, a resin film which is previously heat-shrunk so that the heat shrinkage rate by heating at 150°C for 30 minutes is 0.3 % or lower is used as the resin film and the rear surface protecting layer in order to improve moisture proofness. Thus, the solar cell module can be manufactured with high yields.

A polyphenylene sulfide film can replace with the lamination of a PVDF film and a PET film, and the PET film. Such the films can provide the same effect as mentioned above.

In the above embodiment, because the resin film previously heat shrunk by the heating process is used as the resin film 40 and the rear surface protecting film 20, the resin film 40 and the rear surface protecting film 20 heat-shrink little in the manufacturing processes (the vacuum lamination process and the heating process for bridging). As a result, the copper foil 3a does not deform and the solar cells 3 do not shift the positions. Furthermore, the resin film 40 can completely cover the surface of the solar cell array and an end surface of the resin film 40 is covered with the EVA resin. Thus, the weather proofness and the moisture proofness do not degrade. In addition, because the rear surface protecting film 20 is as large as the front surface protecting layer 1 of the glass plate, it is not necessary to cut off redundancy of the rear surface protecting film 20.

Instead of the resin film previously heat shrunk by the heating process used as the resin film 40 and the rear surface protecting film 20, a resin film with a lower heat shrinkage rate can be used to obtain the same effect as in the above embodiment. For example, the rear surface protecting film 20 of a PVDF film (120 µm in thickness) can be used in the vacuum lamination process and the thermal bridge process.

When the resin film of such the material does not need a process for heat shrinkage, and the number of processes can be reduced. When the resin film of the heat shrinkage rate (at 150°C, 30 minutes) 1.0 % or lower is used as the resin film 40 and the rear surface protecting film 20, a small-sized solar cell module of one meter per side can be manufactured with high yields. When the resin film of the heat shrinkage rate (at 150°C, 30 minutes) 0.3 % or lower is used as the resin film 40 and the rear surface protecting film 20, a large-sized solar cell module of 1-2 meter per side can be manufactured with high yields. An olefin film can replace with the PET film and the PVDF film as the resin film.

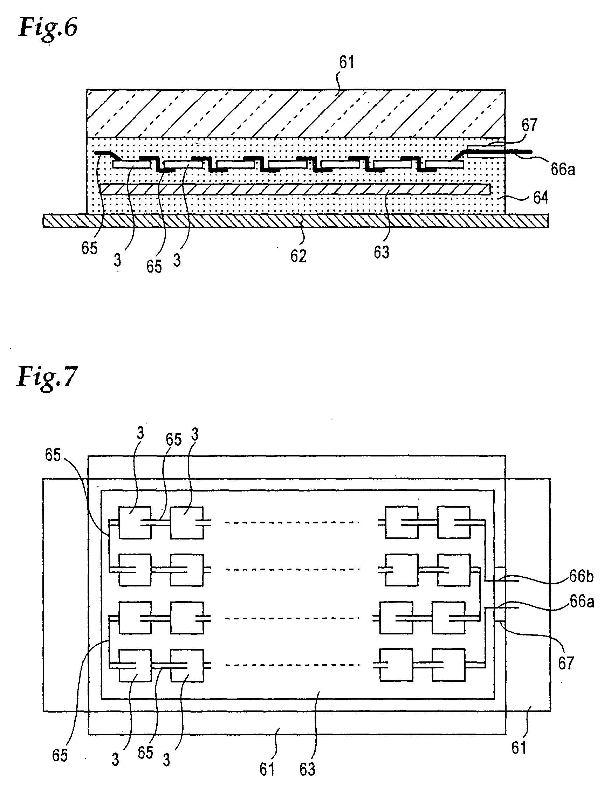

Explanation on a solar cell module of the second embodiment capable of improving insulation performance by forming an insulating film between the solar cell and the rear surface protecting layer of a metal plate is made by referring to Figs. 6 and 7.

Fig. 6 is the schematic cross sectional view of the solar cell module, and Fig. 7 is the plan view of the module. This solar cell module includes a resin film 63 of a PET film of 100 *µ*m in thickness as an insulating film and a plurality of the solar cells 3 sealed by a sealing resin 64 of such as EVA between the rear surface protecting layer 62 of a steel plate and a front surface protecting layer 61 of a glass plate.

The rear surface protecting layer 62 has an area of 1324 by 869 mm, and the front surface protecting layer 61 has an area of 1300 by 875 mm with shorter sides than those of the rear surface protecting layer 62 in a horizontal direction and longer sides than those of the rear surface protecting layer 62 in a vertical direction. An overlaying areas of the protecting layers 61, 62 have an area of 1300 by 869 mm.

The solar cell 3 is a general one which receives light from a front surface side to generate power. The solar cells 3 are connected in series by a wiring 65 and the generated power output is taken out from a pair of wirings 66a, 66b in an outlet.

The solar cells 3 have a smaller area than the overlaying area of the protecting layers 61, 62 and are positioned inside the overlaying area.

The resin film 63 is formed to have an area of 1294 by 863 mm, and is positioned inside by 3 mm from the overlaying area of 1300 by 869 mm.

In this case, the resin film 63 has an area as large as or larger than an area surrounding the solar cells 3, and can securely insulate the solar cells 3 and the wiring from the protecting layer 62 of the steel plate.

The moisture proof test same as in the first embodiment is conducted for a module for comparison formed by covering the entire overlaying area of the protecting layers 61, 62 with a PET film (a film for comparison), having an area of 1300 by 869 mm as large as the overlaying area, instead of the resin film 63, and for the module of this embodiment provided with the resin film 63. The results are shown in Table 2.

**Table 2**

| | Change rate of output characteristic | | | |
|---|---|---|---|---|
| | Pmax | Voc | Isc | F.F. |
| Module for comparison (after 1000 hours) | 98.9 | 99.8 | 99.7 | 99.4 |
| Module for comparison (after 2000 hours) | 96.3 | 99.3 | 99.5 | 97.5 |
| Module of the embodiment (after 1000 hours) | 99.1 | 99.8 | 99.8 | 99.5 |
| Module of the embodiment (after 2000 hours) | 98.5 | 99.6 | 99.7 | 99.2 |

The table 2 shows that the output characteristics of the module for comparison are greatly degraded after 2000 hours as compared with the output characteristics of the module of the embodiment.

When visually checking the front surfaces of the modules after the test, the module for comparison after 2000 hours is peeled by approximately 2 mm at an end edge of the film for comparison.

The resin film 63 of the module of the embodiment is interposed inside by 3 mm from the edge of the overlaying part of the protecting layers 61, 62, and thus the large-sized module can have high adhesiveness between the resin film 63 and the sealing resin 64 and can present high insulation characteristics without peeling the resin film 63. Thus, the module of even such the large size can prevent degradation of output characteristics with time.

It is preferred and practical in terms of insulation performance to cover the front and rear surfaces of the wirings 66a, 66b at the outlet drawn out from the resin film 63 with an insulating tape 67 to insulate the wirings.

The insulating tape 67 can cover the wirings 66a, 66b by any ways, for example, it can sandwich and cover the wirings from front and rear surface sides.

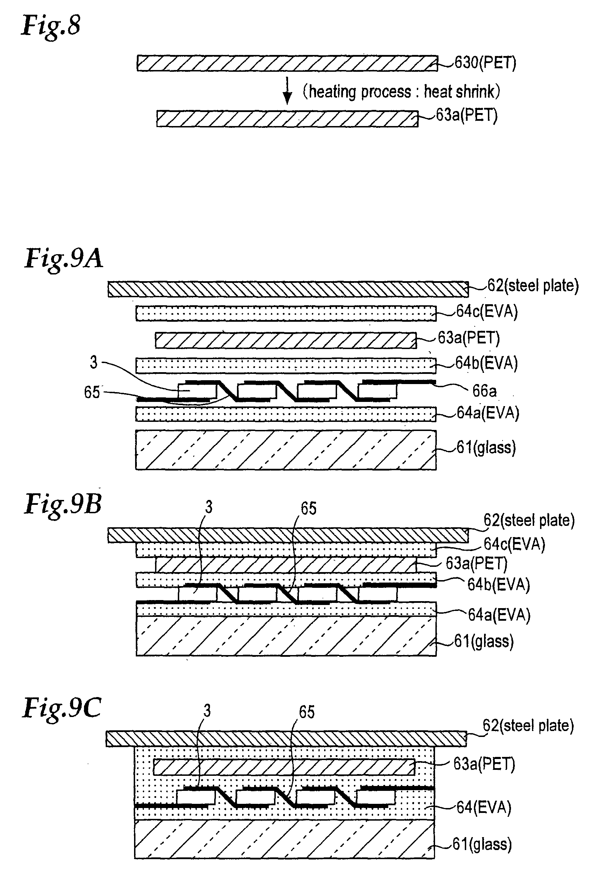

A manufacturing method of the module of the second embodiment using a film little affected by the heat shrinkage of the resin film in the heating process is explained by referring to Figs. 8, 9.

A resin film 630 of a PET film (100 µm in thickness) is heat-shrunk by a heating process at 150°C for 30 minutes, same as a thermal bridge process described later, to obtain an insulation preventing film 63a (see Fig. 8).

Then, a glass plate 61 (3-5 mm in thickness) with a reinforced front surface, a first resin layer 64a of EVA resin (0.6 mm in thickness), the solar cell array including a plurality of the solar cells 3 of 100 mm per side electrically connected by a copper foil 65, a second resin layer 64b of EVA resin (0.4 mm in thickness), the insulation preventing film 63a, a third resin layer 64c of EVA resin (0.4 mm in thickness), and a rear surface metal plate 62 of a steel plate are laminated in this order (see Fig. 9A). In this case, the insulating preventing film 63a is larger than the solar cell array, but is smaller than the first, second, and third resin layers 64a, 64b, 64c.

This lamination is tentatively adhered by a vacuum lamination process (pressing for 2-10 minutes at 90-130°C) (see Fig. 9B). Then, the lamination is heated to thermally bridge the first, second, and third resin layers 64a, 64b, and 64c for example at 150°C for 30 minutes, and the lamination is integrated with the solar cell array and the insulation preventing film 63a sealed by the sealing layer 64 of EVA resin to form the solar cell module (see Fig. 9C).

It is desirable that a condition of the heating process satisfies that the heat shrinkage rate of the resin film after heating at 150°Cfor 30 minutes is 1.0 % or lower, more preferably 0.3% or lower. For example, in manufacturing a solar cell module of a rectangular shape of not longer than one meter per side, the resin film which is previously heat-shrunk so that the heat shrinkage rate by heating at 150°C for 30 minutes is 1.0 % or lower is used as the insulation preventing film. Thus, the solar cell module can be manufactured with high yields. In manufacturing a large sized solar cell module of 1-2 meter per side, the resin film which is previously heat-shrunk so that the heat shrinkage rate by heating for 30 minutes at 150°C is 0.3 % or lower is used as the insulation preventing film. Thus, the solar cell module can be manufactured with high yields.

A PVF film, and a polyphenylene sulfide film can replace with the PET film as the resin film. Such the films can provide the same effect as mentioned above.

Instead of the resin film which is previously heat shrunk by the heating process and is used as the resin film 63a, a resin film with a lower heat shrinkage rate can be used to obtain the same effect as in the above embodiment. For example, the resin film 63a of a PVDF film can be used in the vacuum lamination process and the thermal bridge process.

The resin film of such the material does not need a process for heat shrinkage, and the number of processes can be reduced. When the resin film of the heat shrinkage rate (at 150°C for 30 minutes) 1.0 % or lower is used as the resin film 63a, a small-sized solar cell module of one meter per side can be manufactured with high yields. When the resin film of the heat shrinkage rate (at 150°C for 30 minutes) 0.3 % or lower is used as the resin film 63a, a large-sized solar cell module of 1-2 meter per side can be manufactured with high yields. An olefin film can replace with the PET film and PVDF film as the resin film.

The second embodiment of this invention can be applied to an amorphous solar cell module with a plurality of solar cells formed of an amorphous semiconductor directly formed on a glass plate. In this case, the EVA resin layer, the insulation preventing film formed of a heat shrunk plastic film, and the EVA resin layer are laminated in this order on a glass plate surface with the solar cells formed thereon and are integrated. This structure also provides the same effect as in the case above described.

As described in the above embodiment, when the resin films 4, 63 are formed inside by at least 3 mm from the edge of the overlaying area of the rear surface protecting layers 2, 62 and the front surface protecting layers 1, 61, the resin films 4, 63 are prevented from peeling and the output characteristics are prevented from degrading with time. The resin film 4 is preferred to be as large as or larger than the solar cells 3 in terms of moisture proofness, and the resin film 63 is preferred to have an area enough to cover at least the solar cells 3 and the wiring 65 in terms of insulation characteristics.

The resin films 4, 63 may be other than hard PET, for example may be such as polyester, polyphenylene sulfide film, polyimide film, poly vinyl chloride, polycarbonate, polyphenylene oxide, polysulfone, polyethersulfone, poly vinyl fluoride (PVF), PVDF.

Shapes, sizes, and thickness of the resin films 4, 63 and the protecting layers 1, 2, 61, and 62 are not limited to the ones described in the embodiments. In addition, the shapes and sizes of the rear surface protecting layers 2, 62 and the front surface protecting layers 1, 61 may be any one as long as the overlaying area of them can cover at least the solar cells 3, and the shapes and sizes of the rear surface protecting layers 2, 62 and the front surface protecting layers 1, 61 can be different.

This invention can be applied to a general solar cell module which receives light from one side to generate power other than the solar cell module of double side power generation which receives light from both front and rear surfaces to generate power as described in the embodiment.

This invention can be applied to a solar cell module including the resin film for improving moisture proofness between the front surface protecting layer and the solar cells, and the resin film for improving insulation performance between the solar cells and the rear surface protecting layer.

This invention can apply to any sizes and types of solar cell modules to achieve the same effect as in the above embodiments.

Although the present invention has been described and illustrated in detail, it should be clearly understood that the description discloses examples of different embodiments of the invention and is not intended to be limited to the examples or illustrations provided. Any changes or modifications within the spirit and scope of the present invention are intended to be included, the invention being limited only by the terms of the appended claims.

## Claims

1. A solar cell module comprising a front surface protecting layer, a rear surface protecting layer, and a solar cell and a resin film sealed by sealing resin between the front surface protecting layer and the rear surface protecting layer,
wherein the resin film is smaller in size than an overlaying area of the front surface protecting layer and the rear surface protecting layer.

2. The solar cell module according to claim 1,
wherein the front surface protecting layer is a glass plate and the rear surface protecting layer is a transparent resin film.

3. The solar cell module according to claim 1,
wherein the resin film is a film which is previously heat-shrunk or a film of a small heat shrinkage rate.

4. The solar cell module according to claim 2,
wherein the rear surface protecting layer is a film which is previously heat-shrunk or a film of a small heat shrinkage rate.

5. The solar cell module according to claim 1,
wherein the resin film is formed inside from an edge of the overlaying area of both of the protecting layers.

6. The solar cell module according to claim 3,
wherein the resin film is formed inside by at least 3 mm from the edge of the overlaying area of the front surface protecting layer and the rear surface protecting layer.

7. The solar cell module according to claim 2,
wherein the resin film is formed between the front surface protecting layer and the solar cell, and the resin film is overlaid on an area including at least the solar cells within the overlaying area of the front surface protecting layer and the rear surface protecting layer.

8. The solar cell module according to claim 1,
wherein the front surface protecting layer is a glass plate, the rear surface protecting layer is a metal plate, the resin film is formed between the solar cell and the rear surface protecting layer, and the resin film is overlaid on an area including at least the solar cells and a wiring of the cells within the overlaying area of the front surface protecting layer and the rear surface protecting layer.

9. The solar cell module according to claim 8,
wherein the wiring protruded from the resin film is covered with an insulating tape.
